(19) Europäisches Patentamt
European Patent Office
Office européen des brevets

(11) **EP 1 075 168 B1**

(12) **FASCICULE DE BREVET EUROPEEN**

(45) Date de publication et mention
de la délivrance du brevet:
**17.02.2010 Bulletin 2010/07**

(51) Int Cl.:
***H05H 1/46*** *(2006.01)*

(21) Numéro de dépôt: **00420172.9**

(22) Date de dépôt: **02.08.2000**

(54) **Procédé de production d'un plasma élémentaire en vue de créer un plasma uniforme pour une surface d'utilisation et dispositif de production d'un tel plasma**

Verfahren zur Erzeugung eines Grundplasmas, um ein gleichförmiges Plasma für eine Zieloberfläche zu erzeugen und Erzeugungsvorrichtung dafür

Method for generating an elementary plasma in order to produce a uniform plasma for a target surface and device for generating such a plasma

(84) Etats contractants désignés:
**AT BE CH CY DE DK ES FI FR GB GR IE IT LI LU MC NL PT SE**

(30) Priorité: **04.08.1999 FR 9910291**

(43) Date de publication de la demande:
**07.02.2001 Bulletin 2001/06**

(73) Titulaire: **ST PLASMAS**
**42160 Andrezieux-Boutheon (FR)**

(72) Inventeurs:
• **Lagarde, Thierry**
**38450 Vif (FR)**
• **Pelletier, Jacques**
**38400 Saint Martin d'Heres (FR)**

(74) Mandataire: **Thivillier, Patrick et al**
**Cabinet Laurent & Charras**
**3 Place de l'Hôtel de Ville**
**B.P. 203**
**42005 Saint-Etienne Cedex 1 (FR)**

(56) Documents cités:
**EP-A- 0 613 329    EP-A- 0 711 100**
**US-A- 4 473 736    US-A- 5 180 948**
**US-A- 5 844 217**

• **PATENT ABSTRACTS OF JAPAN vol. 018, no. 116 (E-1515), 24 février 1994 (1994-02-24) & JP 05 314918 A (NISSIN ELECTRIC CO LTD), 26 novembre 1993 (1993-11-26)**

## Description

La présente invention concerne le domaine technique général de la production de plasma à basse pression excité par une énergie micro-onde dans le domaine de la résonance cyclotronique électronique.

L'objet de l'invention concerne toutes les applications nécessitant une uniformité de plasma contrôlable sur des grandes surfaces présentant un caractère plan ou courbe.

La présente invention concerne des applications très diverses, telles que les traitements de surface, comme la gravure, le dépôt, le traitement chimique ou thermochimique, la pulvérisation, le nettoyage, la désinfection, la décontamination ou la production de faisceaux d'ions obtenus par extraction du plasma.

Dans le domaine de la technique d'excitation d'un plasma à la résonance cyclotronique électronique, la résonance est obtenue lorsque la fréquence de giration d'un électron dans un champ magnétique statique ou quasi statique est égale à la fréquence du champ électrique accélérateur appliqué. Cette résonance est obtenue pour un champ magnétique **B** et une fréquence d'excitation **f** liée par la relation :

$$\mathbf{B} = 2\pi \mathbf{mf/e}$$

où **m** et **e** sont la masse et la charge de l'électron.

Dans le cas de l'excitation d'un plasma, la résonance cyclotronique électronique est efficace uniquement si l'électron est suffisamment accéléré, c'est-à-dire si l'électron peut tourner suffisamment longtemps en phase avec le champ électrique pour acquérir l'énergie de seuil nécessaire à l'ionisation du gaz. Pour satisfaire cette condition, il faut, d'une part, que le rayon de giration de l'électron soit suffisamment petit, en particulier, pour rester dans la région de l'espace réunissant les conditions de résonance c'est-à-dire la présence simultanée du champ électrique et du champ magnétique et, d'autre part, que la fréquence de giration **f** reste grande devant la fréquence de collision des électrons sur les éléments neutres, tels que les atomes et/ou les molécules. Autrement dit, les meilleures conditions d'excitation d'un plasma à la résonance cyclotronique électronique sont obtenues à la fois pour une pression de gaz relativement faible et une fréquence **f** de champ électrique élevée, c'est-à-dire aussi pour une intensité de champ magnétique **B** élevée.

Le brevet français n° 85 08 836 décrit une technique d'excitation de plasma à la résonance cyclotronique électronique nécessitant la mise en oeuvre d'aimants permanents créant chacun au moins une surface à champ magnétique constant et d'intensité correspondant à la résonance cyclotronique électronique. L'énergie micro-onde est amenée au niveau de la zone de résonance par l'intermédiaire d'antennes ou d'excitateurs de plasma constitués chacun par un élément filaire métallique. Chaque excitateur s'étend à proximité et le long d'un aimant en étant disposé au droit d'un aimant permanent.

Le champ magnétique d'intensité égale à la valeur donnant la résonance et le champ électrique micro-onde sont tous les deux localisés et confinés essentiellement dans l'espace situé entre un excitateur et la partie de la paroi de l'enceinte placée en regard d'un aimant. En présence d'un milieu gazeux présentant une pression réduite, les électrons sont accélérés dans la zone de résonance et s'enroulent le long des lignes de champ magnétique qui définissent une surface de confinement du plasma. Ces lignes de champ en forme de festons relient le pôle d'un aimant à son pôle opposé ou au pôle opposé d'un aimant consécutif. Le long de son trajet, l'électron dissocie et ionise les molécules et les atomes avec lesquels il entre en collision. Le plasma ainsi formé dans les festons de champ magnétique diffuse ensuite, à partir des lignes de champ, pour former un plasma pratiquement exempt des électrons énergétiques qui restent piégés dans les festons.

L'inconvénient majeur de la technique décrite par ce brevet a trait au fait que la zone de propagation de l'énergie micro-onde et la zone de résonance où l'énergie micro-onde est absorbée se superposent. La propagation des micro-ondes ne peut donc s'effectuer qu'avec des pertes et l'intensité du champ électrique micro-onde et la densité du plasma diminuent tous deux progressivement le long de l'excitateur à partir de la source micro-onde. Le plasma obtenu présente une densité non uniforme le long de l'excitateur, de sorte qu'un tel plasma apparaît inadapté à la plupart des applications industrielles.

Une variante de la technique décrite ci-dessus fait l'objet du brevet français n° 93 02 414. Selon cette technique, les micro-ondes sont appliquées directement à l'une des extrémités de l'applicateur de champ magnétique constitué par des aimants permanents ou par un conducteur parcouru par un courant électrique. Cette fois encore, les micro-ondes se propagent principalement dans la zone de résonance cyclotronique électronique et subissent donc une forte atténuation, ce qui conduit à la production d'un plasma non uniforme le long de l'aimant. L'intérêt de cette solution par rapport à la technique précédente est, d'une part, la simplification du dispositif et, d'autre part, une efficacité accrue de l'excitation du plasma, dans la mesure où l'intensité du champ magnétique et l'intensité du champ électrique micro-onde sont toutes les deux maximums à la surface de l'applicateur.

Dans le même sens, la demande de brevet JP 05 314 918 décrit un dispositif de production d'un plasma constitué par un applicateur filaire d'une énergie micro-onde, équipé à son extrémité d'un aimant.

Afin de remédier au défaut d'uniformité du plasma lié à la propagation d'une onde progressive fortement atténuée, le brevet français n° 91 00 894 propose d'exciter le plasma à l'aide d'une onde stationnaire d'amplitude constante. A cet effet, il est proposé de faire propager les micro-ondes dans une zone distincte de celle où les conditions de résonance cyclotronique électronique sont remplies. La solution proposée est d'appliquer la puissance micro-onde à l'aide d'un applicateur filaire situé non pas en face des pôles des aimants, mais à mi-distance de deux pôles opposés voisins dans la zone interdite au plasma. Ainsi, il est possible d'obtenir un plasma uniforme le long des aimants, les maxima et les minima de champs micro-ondes dus à l'onde stationnaire le long des aimants étant "gommés" par la vitesse de dérive des électrons le long des aimants, perpendiculairement au plan du champ magnétique.

La généralisation de l'utilisation d'ondes stationnaires pour exciter des plasmas uniformes à la résonance cyclotronique électronique est proposée dans le brevet français n° 9413 499 où l'établissement des ondes stationnaires est contrôlé par l'adjonction de propagateurs filaires auprès de l'applicateur des micro-ondes, disposés en dehors de la zone d'absorption des micro-ondes à la résonance cyclotronique électronique.

Toutefois, les techniques décrites par ces brevets n° 91 00 894 et n° 94 13 499 où la propagation des micro-ondes s'effectue sous forme d'ondes stationnaires présentent la difficulté d'obtenir une amplitude constante, notamment pour une longueur relativement importante de l'applicateur micro-ondes. En outre, l'ajustement de l'uniformité et de l'amplitude impose généralement d'utiliser une adaptation d'impédance en amont de l'applicateur micro-ondes.

L'analyse des différentes techniques de l'art antérieur conduit à constater des défauts d'uniformité du champ électrique et du plasma le long des applicateurs, dus à la très forte atténuation du champ électrique par absorption résonante de la puissance micro-onde par les électrons à la résonance cyclotronique électronique. Autrement dit, les techniques décrites ci-dessus ne permettent pas de produire un plasma uniforme sur de grandes longueurs et donc sur de grandes surfaces typiquement, sur des dimensions de l'ordre du mètre ou supérieur. En outre, ces techniques présentent un inconvénient majeur, à savoir le rayonnement des micro-ondes à partir des applicateurs et des propagateurs, dû au confinement médiocre de la puissance micro-onde dans la zone de propagation. Il en résulte des couplages entre les applicateurs particulièrement néfastes pour l'obtention de bonnes uniformités de plasma. Un autre inconvénient réside dans la difficulté de réaliser et d'introduire dans une enceinte sous vide des applicateurs ou des propagateurs non rectilignes. Il en résulte une quasi impossibilité de traiter de façon uniforme des surfaces courbes.

L'objet de l'invention vise donc à remédier aux inconvénients des techniques antérieures en proposant un procédé permettant de produire un plasma uniforme en relation d'une surface d'utilisation de dimensions relativement importantes.

Un autre objet de l'invention est d'offrir un procédé de production d'un plasma uniforme en relation d'une surface d'utilisation de forme plane ou courbe.

Pour atteindre les divers objectifs énoncés ci-dessus, l'objet de l'invention concerne un procédé de production d'un plasma pour une surface d'utilisation, à l'aide d'un dispositif comportant des moyens de production d'une énergie dans le domaine des micro-ondes et des moyens pour créer au moins une surface à champ magnétique constant et d'intensité correspondant à la résonance cyclotronique électronique et placée au moins dans la zone de propagation des micro-ondes, en vue de l'excitation du plasma.

Selon l'invention, le procédé consiste :

- à constituer une série de dispositifs élémentaires d'excitation de plasma constitués chacun par un applicateur d'une énergie micro-onde dont une extrémité est reliée à une source de production d'une énergie micro-onde et dont l'autre extrémité est équipée d'au moins un dipôle magnétique en tant que moyens pour créer au moins une surface à champ magnétique constant et d'intensité correspondant à la résonance cyclotronique électronique,

- à monter le dipôle magnétique à l'extrémité de l'applicateur micro-ondes, de manière à assurer l'oscillation entre les pôles des électrons accélérés à la résonance cyclotronique électronique, en vue de créer une zone de diffusion de plasma située au moins à l'opposé de l'extrémité de l'applicateur, par rapport audit dipôle,

- et à répartir les dispositifs élémentaires d'excitation de plasma entre eux et en relation de proximité de la surface d'utilisation, de manière à obtenir au moins une juxtaposition entre les plasmas produits par chaque dispositif élémentaire, en vue de créer un plasma uniforme pour la surface d'utilisation.

Un autre objet de l'invention vise à proposer un dispositif de production d'un plasma en relation d'une surface d'utilisation, le dispositif comportant des moyens de production d'une énergie dans le domaine des micro-ondes, et des moyens pour créer au moins une surface à champ magnétique constant et d'intensité correspondant à la résonance cyclotronique électronique et placée au moins dans la zone de propagation des micro-ondes, en vue de l'excitation du plasma.

Selon l'invention, le dispositif comprend une série de dispositifs élémentaires d'excitation de plasma, constitués chacun par un applicateur filaire d'une énergie micro-onde dont une extrémité est reliée à la source de production et dont l'autre extrémité est équipée, en tant que moyens pour créer au moins une surface à champ magnétique constant et d'intensité correspondant à la résonance cyclotronique électronique, d'au moins un dipôle magnétique monté à l'extrémité de l'applicateur micro-ondes, de manière à assurer l'oscillation entre les pôles des électrons accélérés à la résonance cyclotronique électronique, en vue de créer une zone de diffusion de plasma située à l'opposé de l'extrémité de l'applicateur par rapport audit dipôle, les dispositifs élémentaires d'excitation étant répartis entre eux et en relation de proximité de la surface d'utilisation, en vue de créer ensemble un plasma uniforme pour la surface d'utilisation.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

La **fig. 1** est une vue schématique en élévation permettant d'illustrer un dispositif de production d'un plasma conforme à l'invention.

La **fig. 2** est une vue de dessus montrant un exemple de réalisation d'un dispositif de production d'un plasma conforme à l'invention.

Les **fig. 3** à **8** illustrent diverses variantes de réalisation d'un dispositif élémentaire d'excitation de plasma faisant partie d'un dispositif de production conforme à l'invention.

Les **fig. 9** et **10** sont des schémas illustrant divers montages des dispositifs élémentaires d'excitation entre eux.

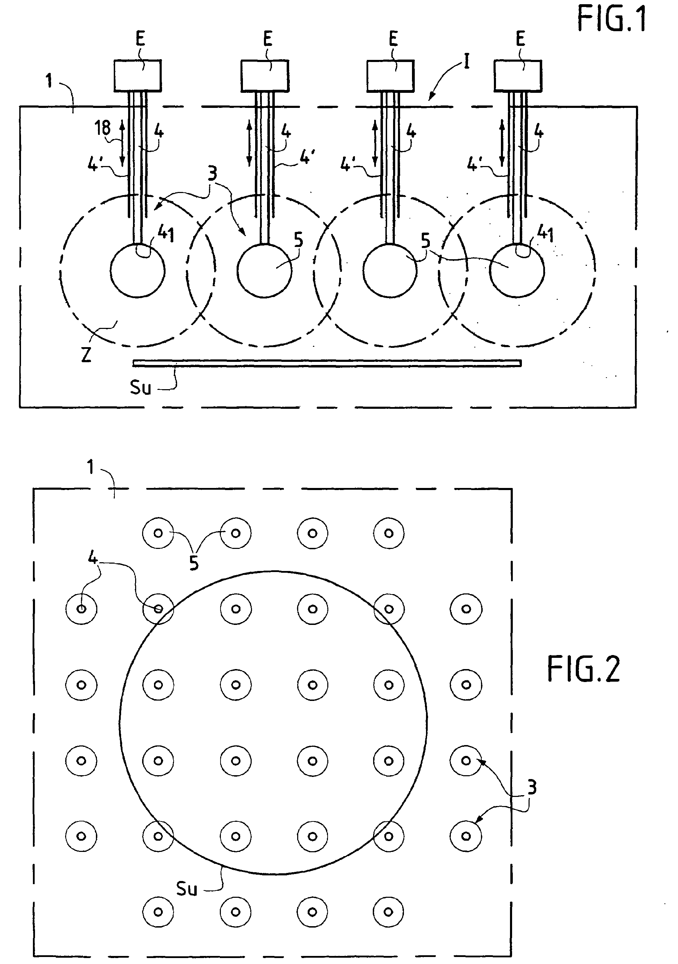

Les **fig. 1** et **2** illustrent, à titre d'exemple, un dispositif **I** de production d'un plasma en relation d'une surface d'utilisation au sens général $S_u$, pouvant constituer, par exemple, une surface susceptible de recevoir différents traitements de surface. Le dispositif **I** comprend, de façon classique, une enceinte étanche **1** représentée à titre schématique, équipée de dispositifs d'introduction de gaz et de pompage de gaz, non représentés mais connus en soit, permettant de maintenir la pression du gaz à ioniser à une valeur souhaitée qui peut être par exemple de l'ordre de $10^{-3}$ à quelques dizaines de Pascals suivant la nature du gaz et la fréquence d'excitation.

Conformément à l'invention, le dispositif de production **I** comporte une série de dispositifs **3** élémentaires d'excitation de plasma répartis entre eux et en relation de proximité de la surface d'utilisation $S_u$, en vue de créer ensemble un plasma uniforme pour cette surface d'utilisation $S_u$. Conformément à l'invention, chaque dispositif élémentaire **3** d'excitation de plasma est constitué par un applicateur d'une énergie micro-onde **4** réalisé sous une forme filaire, c'est-à-dire allongée. L'applicateur filaire **4** est raccordé à l'une des ses extrémités, de préférence, par une structure coaxiale **4'**, à une source d'énergie **E** dans le domaine des micro-ondes, extérieure à l'enceinte **1**. Chaque applicateur filaire **4** se trouve réalisé avantageusement sous la forme d'un tube entouré d'un tube coaxial **4'** permettant ainsi la propagation de l'énergie micro-onde jusqu'à son extrémité libre **4₁** en évitant le rayonnement des micro-ondes et le couplage des micro-ondes entre les applicateurs.

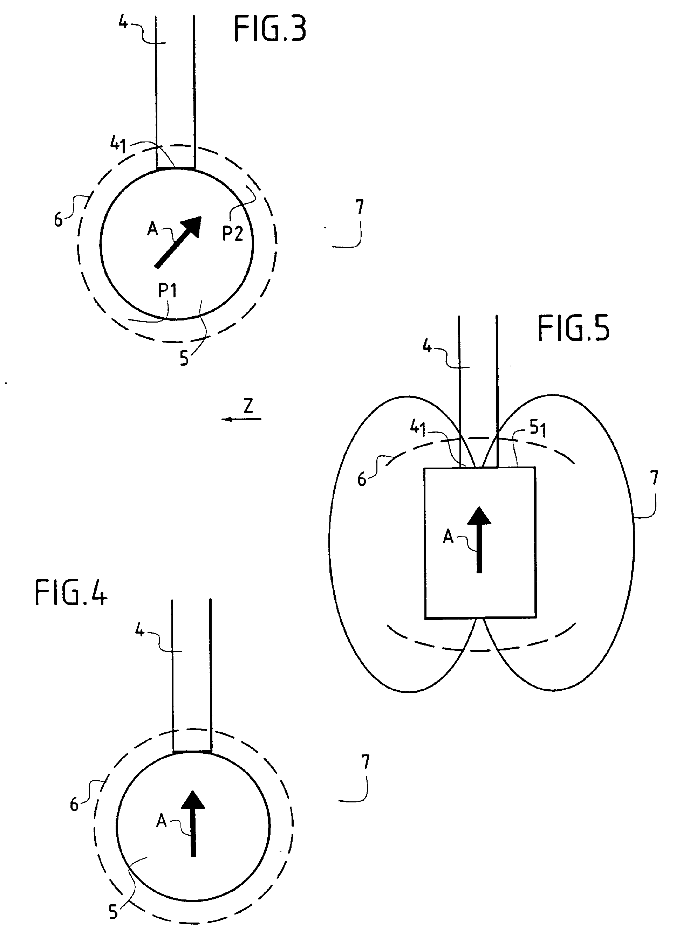

Selon une autre caractéristique de l'invention illustrée plus précisément à la **fig. 3**, chaque applicateur micro-onde **4** est destiné à être relié par son extrémité **4₁** opposée à celle reliée à la source d'énergie micro-onde **E**, à au moins un dipôle magnétique **5** adapté pour créer au moins une surface **6** à champ magnétique et d'intensité correspondant à la résonance cyclotronique électronique. Dans l'exemple de réalisation illustré à la **fig. 3**, le dipôle magnétique **5** est constitué par un aimant permanent de forme sphérique, dont la direction d'aimantation **A** et la position des pôles nord **N** et sud **S** par rapport au point d'application des micro-ondes, à savoir l'extrémité **4₁** de l'applicateur, sont quelconques. Cet aimant permanent **5** crée ainsi une surface **6** autour de la sphère correspondant à la condition de résonance cyclotronique électronique, tandis que les lignes **7** représentent les lignes de champ magnétique qui joignent les deux pôles opposés de l'aimant et qui convergent à ces pôles. Entre deux collisions, les électrons accélérés au niveau de la zone de résonance **6** par le champ électrique micro-onde appliqué par l'applicateur filaire **2**, oscillent entre le pôle nord et le pôle sud et entre les lignes de champ **7**. De façon avantageuse, ces électrons accélérés à la résonance cyclotronique électronique oscillent entre des points miroirs **P₁, P₂** situés à proximité et face à chaque pôle, et présentent une même intensité de champ magnétique, conformément à la théorie décrite dans le livre intitulé "MICROWAVE EXCITED PLASMA", chap. 12, page 368 édité par M. MOISAN et J. PELLETIER, ELSEVIER, Amsterdam (1992). Ces électrons subissent aussi un mouvement de dérive autour de l'axe d'aimantation de l'aimant, ces dérives magnétiques étant dues à la courbure et au gradient du champ magnétique. Le plasma produit par ces électrons le long de leur trajectoire, diffuse ensuite à l'extérieur de la zone source sous l'influence, des gradients de densité du plasma. Il apparaît ainsi une zone **Z** de diffusion de plasma située au moins à l'opposé, par rapport au dipôle **5**, de l'extrémité **4₁** de l'applicateur.

Dans l'exemple de réalisation illustré à la **fig. 3**, il doit être constaté qu'une partie au moins des trajectoires électroniques rencontre l'applicateur filaire **4**, de sorte qu'une partie des électrons se trouve collectée par cet applicateur filaire **4**, de sorte qu'il apparaît une perte pour les électrons.

Pour éviter cette perte d'électrons, il peut être prévu, comme illustré à la **fig. 4,** de placer le dipôle magnétique **5** de manière que son axe d'aimantation **A** se trouve situé sensiblement parallèlement à l'axe de l'applicateur filaire. De préférence, l'axe d'aimantation **A** du dipôle magnétique **5** est situé sensiblement dans le prolongement de l'axe de l'applicateur filaire **4**. Selon cet exemple, les trajectoires électroniques ne rencontrent plus l'applicateur filaire **4** et les électrons peuvent poursuivre leur trajectoire sans obstacle entre deux collisions élastiques ou inélastiques. Dans ce type de fonctionnement, il est ainsi obtenu une structure magnétique tridimensionnelle de type magnétron où les électrons peuvent osciller et dériver indéfiniment sans se perdre sur des parois. En réalité, les électrons rapides ou primaires, accélérés par résonance cyclotronique électronique, perdent inévitablement de l'énergie en produisant le plasma et deviennent des électrons lents ou thermiques contribuant ainsi en partie à la population électronique du plasma.

Selon les exemples de réalisation illustrés aux **fig. 3** et **4**, les aimants permanents **5** sont représentés en ayant une forme sphérique. En fait, dans le cas de l'invention, la forme des aimants importe peu et ceux-ci peuvent être de forme quelconque voire complexe (anneaux, tore, parallélépipède, etc) et présenter des aimantations très variées (par exemple axiale, diamétrale ou radiale). Toutefois, ces aimants **5** doivent présenter une aimantation suffisante pour générer la condition de résonance cyclotronique électronique. En outre, comme dans le cas des aimants sphériques, il est préférable que ces aimants puissent constituer une structure de type magnétron dans laquelle l'application des micro-ondes n'entraîne pas de perte d'électrons.

Selon une solution préférée de réalisation illustrée à la **fig. 5**, chaque dipôle **5** est constitué par un aimant de forme cylindrique présentant une aimantation axiale **A** qui se trouve sensiblement située dans le prolongement de l'axe de l'applicateur filaire **4**. L'un des pôles de l'aimant délimité par une surface transversale **5₁**, est destiné à être en contact avec l'extrémité **4₁** de l'applicateur pour permettre l'application des micro-ondes. Il est ainsi obtenu une structure magnétique de type magnétron à symétrie de révolution. Selon cet exemple de réalisation, il est à noter que certaines lignes de champ **7** viennent converger au niveau du pôle situé à l'extrémité **4₁** de l'applicateur, en rencontrant ledit applicateur filaire **4**, ce qui entraîne encore des pertes d'électrons significatives.

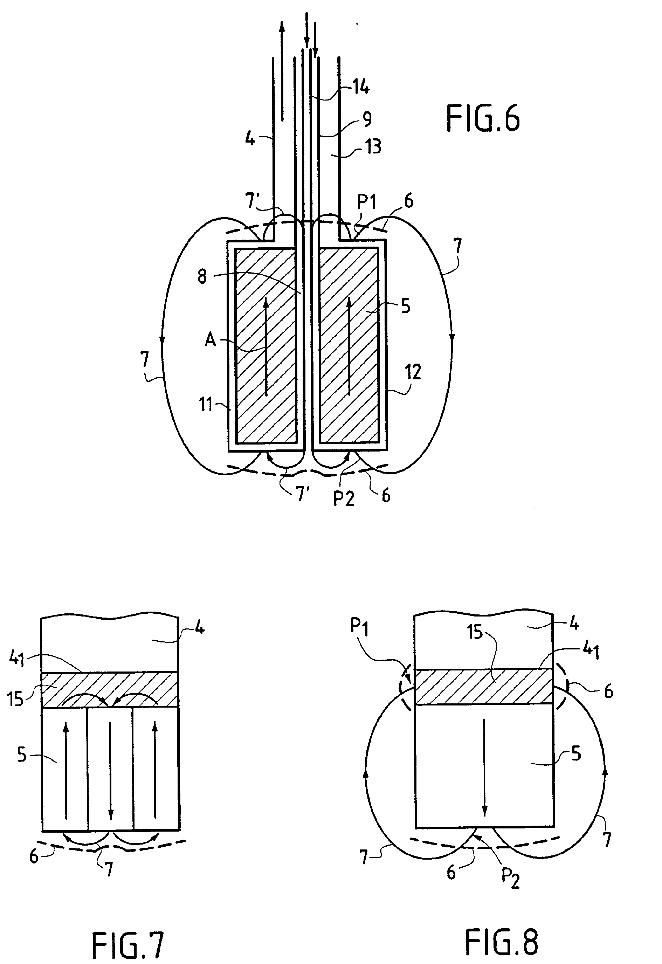

Pour éviter un tel inconvénient, il peut être prévu de réaliser un aimant **5** cylindrique d'aimantation axiale et comportant un alésage central **8** suivant l'axe de l'aimant. Selon cet exemple de réalisation illustré à la **fig. 6**, une partie **7'** des lignes de champ magnétique passe désormais dans l'alésage central **8** de l'aimant. En outre, les pôles magnétiques ne sont plus ponctuels mais décrivent des cercles centrés sur l'axe de révolution de l'aimant vers lesquels les lignes de champ magnétique **7** et **7'** convergent. Aussi, si le diamètre de l'enveloppe externe de l'applicateur **4** est égal au diamètre du cercle décrit par le pôle magnétique, les électrons accélérés par la résonance cyclotronique électronique ne peuvent pas décrire de trajectoires s'appuyant sur les lignes de champ **7'**. Il apparaît ainsi que l'extrémité **4₁** de l'applicateur filaire ne franchit pas le pôle magnétique. Les seules lignes de champ utiles sont donc les lignes de champ **7** extérieures à l'aimant et, par conséquent, aucune trajectoire électronique ne rencontre l'applicateur filaire **4** entre deux points miroirs **P₁, P₂**. Il n'apparaît donc pas de perte d'électrons et il peut être ainsi obtenu des performances optimales en termes de rendement énergétique.

Selon cette caractéristique préférée de réalisation, chaque alésage axial **8** peut être utilisé pour permettre le montage d'une canalisation **9** d'amenée d'un fluide de refroidissement et servant avantageusement de support de montage pour l'aimant **5**. Cette canalisation **9** réalisée sous la forme d'un tube communique, à son extrémité, avec une enceinte **11** délimitée entre l'aimant et une enveloppe **12** entourant à distance l'aimant. L'enceinte **11** débouche dans une conduite **13** de retour du fluide de refroidissement délimitée entre la canalisation d'amenée **9** et l'applicateur filaire **4** constitué par un tube. L'aimant **4** se trouve ainsi encapsulé par l'enveloppe de protection **12** permettant la circulation d'un fluide de refroidissement autour de l'aimant. Par exemple, le matériau d'encapsulation de l'aimant et celui constituant les applicateurs filaires **4** sont réalisés en matériau amagnétique bon conducteur (métaux non magnétiques), mais ils peuvent être également entourés, pour des raisons de contamination, par des matériaux diélectriques sans nuire au bon fonctionnement du dispositif.

Selon une autre caractéristique possible de réalisation, il est à noter qu'il peut être envisagé d'équiper chaque dipôle magnétique **5** d'une conduite **14** d'amenée d'un gaz traversant le dipôle magnétique par son alésage axial **8**. Par exemple, la conduite **14** est montée à l'intérieur de la canalisation d'amenée **9** pour déboucher à l'extrémité opposée de l'enveloppe **12**.

La **fig. 7** illustre une autre variante de réalisation dans laquelle chaque dipôle magnétique **5** présente une face polaire délimitée par un matériau à haute perméabilité magnétique **15**, tel que par exemple une plaquette de fer doux sur laquelle est montée l'extrémité **4₁** de l'applicateur filaire **4**. Un tel dipôle magnétique **5** est constitué pour présenter des pôles magnétiques adjacents. Ainsi, tel que cela apparaît sur la **fig. 7**, il peut être obtenu, à partir d'aimants concentriques accolés nord/sud montés alternativement de manière opposée, des lignes de champ **7** s'établissant entre deux pôles adjacents consécutifs situés sur une face polaire opposée à la face polaire constituée par la plaquette **15**.

La **fig. 8** illustre une variante de réalisation à celle décrite à la **fig. 7**. Selon cette variante, le dipôle magnétique **5** présente une face polaire délimitée par la plaquette **15** sur laquelle est montée l'extrémité **4₁** de l'applicateur filaire **4**. Le dipôle **5** est constitué par un aimant à aimantation axiale prolongeant l'axe de l'applicateur filaire **4**. Dans cette configuration, les électrons sont accélérés à la résonance cyclotronique électronique à partir des lignes correspondantes **6** et oscillent entre deux points miroirs **P₁, P₂**. L'un **P₁** des points n'est plus situé en face du pôle de l'aimant mais sur le côté, le long de l'applicateur filaire **4**, tandis que l'autre point **P₂** reste en face du pôle. Ainsi, la présence de la plaquette **15** disposée au-delà de l'extrémité **4₁** de l'applicateur filaire, permet de modifier la position spatiale des points miroirs **P₁, P₂** associés aux pôles de chaque dipôle magnétique **5**. Ces deux exemples de réalisation décrits aux **fig. 7** et **8**, ne sont pas limitatifs des autres positions relatives du ou des matériaux **15** par rapport à la configuration des aimants **5**.

Tel que cela découle directement de la description qui précède, le procédé selon l'invention consiste donc à constituer une série de dispositifs élémentaires d'excitation de plasma **3** permettant de créer chacun au moins une surface **6** à champ magnétique constant et d'intensité correspondant à la résonance cyclotronique électronique. Un dipôle magnétique **5** est monté à l'extrémité de l'applicateur micro-ondes, de manière à assurer l'oscillation des électrons entre les pôles, en vue de créer une zone de diffusion de plasma **Z** située au moins à l'opposé de l'extrémité **4₁** de l'applicateur par rapport au dipôle. Ensuite, il est prévu de répartir les dispositifs élémentaires d'excitation de plasma **3** entre eux et en relation de proximité de la surface d'utilisation **Sᵤ**, de manière à obtenir au moins une juxtaposition entre les plasmas produits par chaque dispositif élémentaire, en vue de créer un plasma uniforme pour la surface d'utilisation. Il doit être compris que les plasmas élémentaires produits par les dispositifs **3** se recouvrent ou se chevauchent au moins en partie, afin d'obtenir un plasma uniforme pour la surface d'utilisation **Sᵤ**.

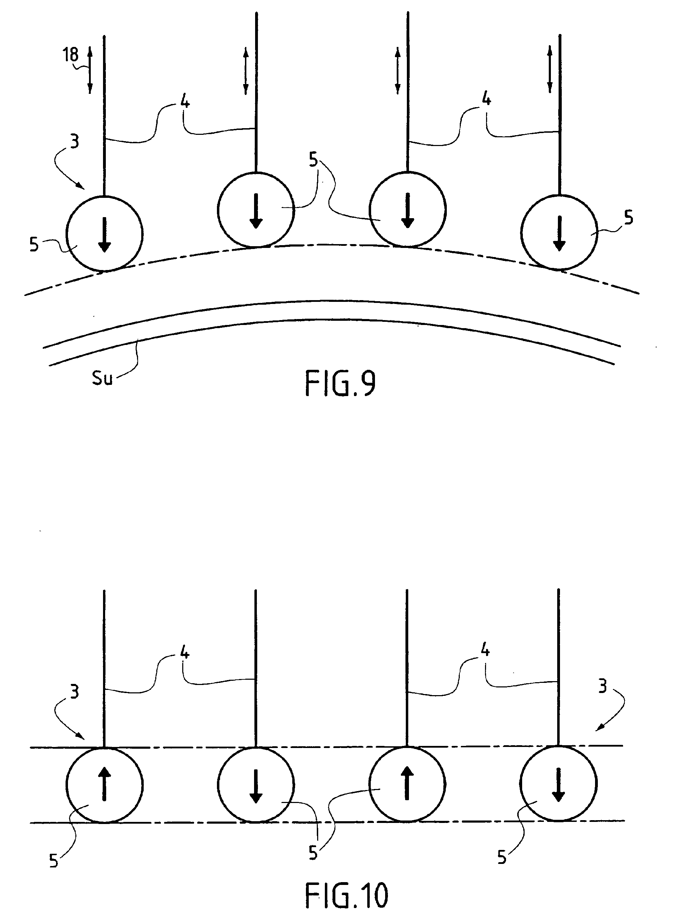

Selon une caractéristique préférée de réalisation, il est prévu de régler la distance entre les dispositifs élémentaires d'excitation **3** et la surface d'utilisation **Sᵤ**, afin d'ajuster l'excitation de plasma au profil de la surface d'utilisation. Ainsi, tel que cela ressort plus précisément des **fig. 1** et **9**, chaque dispositif élémentaire d'excitation de plasma **3** comporte des moyens **18** de réglage du déplacement axial de l'applicateur filaire **4**, de manière à régler la distance de chaque dispositif élémentaire **3** par rapport à la surface à traiter **Sᵤ**. Il peut ainsi être obtenu une disposition relative des dispositifs s'adaptant au mieux aux profils des surfaces à traiter, par exemple courbe. De plus, la puissance de l'énergie micro-onde de chaque dispositif élémentaire d'excitation **3** peut être réglée, en vue d'adapter l'uniformité du plasma.

Dans l'exemple de réalisation illustré à la **fig. 9,** les dispositifs élémentaires d'excitation de plasma **3** sont répartis de manière que les dipôles magnétiques **5** possèdent des axes d'aimantation orientés dans un même sens. Il peut ainsi être obtenu à une distance éloignée des dipôles **5**, un champ magnétique faiblement divergent et dont l'intensité décroît lentement.

Dans l'exemple illustré à la **fig. 10,** il est prévu de répartir les dispositifs élémentaires d'excitation de plasma **3**, de manière que les dipôles magnétiques **5** possèdent des axes d'aimantation alternativement orientés d'un dispositif voisin à un autre. Il est ainsi obtenu une structure multipolaire classique avec une décroissance rapide, quasi exponentielle, de l'intensité du champ magnétique en fonction de l'éloignement par rapport aux aimants.

D'après la description qui précède, l'objet de l'invention permet d'obtenir une uniformité de plasma ne dépendant pas des conditions de propagation des micro-ondes et offre la possibilité de traiter des surfaces d'utilisation de grandes dimensions.

Les principaux domaines d'applications de l'invention sont le traitement uniforme (nettoyage, dépôt, gravure, etc) des surfaces de grandes dimensions, planes ou gauches. A titre d'exemple, pour la fabrication des circuits intégrés, il est possible d'effectuer des traitements de surface sur des plaquettes de silicium de diamètre 300 mm en utilisant un réseau de 32 sources élémentaires espacées entre elles de 60 mm (**fig. 2**). Les aimants cylindriques, en samarium-cobalt (Sm-Co), ont 20 mm de diamètre et 30 mm de long et sont réalisés selon l'exemple illustré à la **fig. 6.** Le plasma est excité à la résonance cyclotronique électronique par des micro-ondes à 2,45 GHz, la condition de résonance ($B_0$ = 0,0875 tesla) étant largement remplie par les aimants permanents utilisés. Pour tous les types de procédé développés, l'uniformité obtenue est meilleure que ± 5 %.

L'invention n'est pas limitée aux exemples décrits et représentés, car diverses modifications peuvent y être apportées sans sortir de son cadre.

**Revendications**

1. Procédé de production d'un plasma pour une surface d'utilisation **(Sᵤ)** à l'aide d'un dispositif comportant des moyens de production d'une énergie dans le domaine des micro-ondes et des moyens pour créer au moins une surface **(6)** à champ magnétique constant et d'intensité correspondant à la résonance cyclotronique électronique et placée au moins dans la zone de propagation des micro-ondes, en vue de l'excitation du plasma, **caractérisé en ce qu'**il consiste :

   - à constituer une série de dispositifs élémentaires d'excitation de plasma **(3)** constitués chacun par un applicateur filaire **(4)** d'une énergie micro-onde dont une extrémité est reliée à une source de production **(E)** d'une énergie micro-onde et dont l'autre extrémité est équipée d'au moins un dipôle magnétique **(5)** en tant que moyens pour créer au moins une surface à champ magnétique constant et d'intensité correspondant à la résonance cyclotronique électronique,
   - à monter le dipôle magnétique **(5)** à l'extrémité **(4₁)** de l'applicateur micro-ondes **(4),** de manière à assurer l'oscillation entre les pôles des électrons accélérés à la résonance cyclotronique électronique, en vue de créer une zone de diffusion **(Z)** de plasma située au moins à l'opposé de l'extrémité de l'applicateur, par rapport au dipôle,
   - et à répartir les dispositifs élémentaires d'excitation de plasma **(3)** entre-eux et en relation de proximité de la surface d'utilisation **(Sᵤ)**, de manière à obtenir au moins une juxtaposition entre les plasmas produits par chaque dispositif élémentaire **(3),** en vue de créer un plasma uniforme pour la surface d'utilisation.

**2.** Procédé selon la revendication 1, **caractérisé en ce qu'**il consiste à régler la distance entre les dispositifs élémentaires d'excitation **(3)** et la surface d'utilisation **(S_u)**, afin d'ajuster l'excitation de plasma au profil de la surface d'utilisation.

**3.** Procédé selon la revendication 1 ou 2, **caractérisé en ce qu'**il consiste à régler la puissance de l'énergie micro-onde de chaque dispositif élémentaire d'excitation **(3)**, en vue de régler l'uniformité du plasma.

**4.** Procédé selon la revendication 1, **caractérisé en ce qu'**il consiste à répartir les dispositifs élémentaires d'excitation de plasma **(3)**, de manière que les dipôles magnétiques **(5)** possèdent des axes d'aimantation orientés dans un même sens.

**5.** Procédé selon la revendication 1, **caractérisé en ce qu'**il consiste à répartir les dispositifs élémentaires d'excitation de plasma **(3)**, de manière que les dipôles magnétiques **(5)** possèdent des axes d'aimantation alternativement orientés d'un dispositif voisin à un autre.

**6.** Dispositif de production d'un plasma pour une surface d'utilisation **(S_u)**, le dispositif comportant des moyens de production d'une énergie dans le domaine des micro-ondes, et des moyens pour créer au moins une surface **(6)** à champ magnétique constant et d'intensité correspondant à la résonance cyclotronique électronique et placée au moins en relation de la zone de propagation des micro-ondes, en vue de l'excitation du plasma, **caractérisé en ce qu'**il comprend une série de dispositifs élémentaires d'excitation de plasma **(3),** constitués chacun par un applicateur filaire **(4)** d'une énergie micro-onde, dont une extrémité est reliée à la source de production **(E)** et dont l'autre extrémité est équipée en tant que moyens pour créer au moins une surface à champ magnétique constant et d'intensité correspondant à la résonance cyclotronique électronique, d'au moins un dipôle magnétique **(5)** monté à l'extrémité **(4_1)** de l'applicateur micro-ondes, de manière à assurer l'oscillation entre les pôles des électrons accélérés à la résonance cyclotronique électronique, en vue de créer une zone de diffusion **(Z)** de plasma située à l'opposé de l'extrémité **(4_1)** de l'applicateur par rapport audit dipôle, les dispositifs élémentaires d'excitation **(3)** étant répartis entre eux et en relation de proximité de la surface d'utilisation **(S_u),** en vue de créer ensemble un plasma uniforme pour la surface d'utilisation.

**7.** Dispositif selon la revendication 6, **caractérisé en ce que** chaque dispositif élémentaire d'excitation **(3)** comporte au moins un dipôle magnétique **(5)** dont l'axe d'aimantation **(A)** est situé sensiblement parallèlement à l'axe de l'applicateur filaire **(4).**

**8.** Dispositif selon la revendication 6 ou 7, **caractérisé en ce que** chaque dipôle magnétique **(5)** comporte au moins un matériau **(15)** à haute perméabilité magnétique, placé au-delà de l'extrémité **(4_1)** de l'applicateur filaire, de manière à modifier la position de points miroirs **(P_1, P_2)** associés à chaque pôle d'un dipôle magnétique et entre lesquels oscillent des électrons accélérés à la résonance cyclotronique électronique.

**9.** Dispositif selon l'une des revendications 6 à 8, **caractérisé en ce que** chaque dipôle magnétique **(5)** est constitué par un cylindre aimanté axialement et dans lequel est aménagé un alésage axial **(8)** et **en ce que** le diamètre de l'applicateur filaire **(4)** est égal au diamètre du cercle décrit par le pôle magnétique, en vue d'éviter qu'il coupe les trajectoires des électrons accélérés à la résonance cyclotronique électronique.

**10.** Dispositif selon l'une des revendications 6 à 9, **caractérisé en ce que** chaque dipôle magnétique **(5)** est pourvu d'une canalisation **(9)** d'amenée d'un fluide de refroidissement montée dans un alésage axial et communiquant avec une enceinte **(11)** enveloppant le dipôle magnétique et débouchant dans une conduite de retour **(13)** du fluide de refroidissement.

**11.** Dispositif selon la revendication 10, **caractérisé en ce que** la canalisation de retour **(13)** du fluide de refroidissement est délimitée entre la canalisation d'amenée **(9)** et un tube **(4)** formant l'applicateur filaire.

**12.** Dispositif selon l'une des revendications 9 à 11, **caractérisé en ce que** chaque dipôle magnétique **(5)** est équipé d'une conduite d'amenée de gaz **(14)** traversant le dipôle magnétique par son alésage axial **(8).**

**13.** Dispositif selon l'une des revendications 6 à 12, **caractérisé en ce que** chaque dispositif élémentaire de production **(3)** est équipé de moyens de déplacement axial permettant de régler la distance entre la surface d'utilisation **(S_u)** et le dipôle magnétique **(5).**

**14.** Dispositif selon l'une des revendications 6 à 13, **caractérisé en ce que** chaque applicateur filaire **(4)** est relié par une structure coaxiale **(4')**, à une source d'énergie **(E)** dans le domaine des micro-ondes, extérieure à l'enceinte **(1).**

**Claims**

**1.** Method for producing a plasma for a use surface **(S_u)** using a device comprising means for producing an energy in the microwave range and means for creating at least one surface **(6)** having a constant magnetic field and intensity corresponding to the electron cyclotron resonance and placed at least in the microwave propagation zone, and for exciting the plasma, **characterized in that** it consists:

- in forming a series of elementary plasma excitation devices **(3)** each consisting of a wire microwave energy applicator **(4)** whereof one end is connected to a microwave energy production source **(E)** and whereof the other end is equipped with at least one magnetic dipole **(5)** as means for creating at least one surface having a constant magnetic field and intensity corresponding to the electron cyclotron resonance,

- in mounting the magnetic dipole **(5)** at the end **(4₁)** of the microwave applicator **(4),** in order to ensure the oscillation between the poles of the electrons accelerated to the electron cyclotron resonance, in order to create a plasma diffusion zone **(Z)** located at least opposite the end of the applicator, with regard to the dipole,

- and in distributing the elementary plasma excitation devices **(3)** between one another and close to the use surface **(S$_u$)** in order to obtain at least a juxtaposition between the plasmas produced by each elementary device **(3),** in order to create a uniform plasma for the use surface.

2. Method according to Claim 1, **characterized in that** it consists in adjusting the distance between the elementary excitation devices **(3)** and the use surface **(S$_u$),** in order to adjust the excitation of the plasma to the profile of the use surface.

3. Method according to either of Claims 1 and 2, **characterized in that** it consists in adjusting the microwave energy power of each elementary excitation device **(3),** in order to adjust the uniformity of the plasma.

4. Method according to Claim 1, **characterized in that** it consists in distributing the elementary plasma excitation devices **(3),** so that the magnetic dipoles **(5)** have magnetization axes oriented in the same direction.

5. Method according to Claim 1, **characterized in that** it consists in distributing the elementary plasma excitation devices **(3),** so that the magnetic dipoles **(5)** have magnetization axes alternately oriented from one neighbouring device to the next.

6. Device for producing a plasma for a use surface **(S$_u$),** the device comprising means for producing an energy in the microwave range and means for creating at least one surface **(6)** having a constant magnetic field and intensity corresponding to the electron cyclotron resonance and placed at least in the microwave propagation zone, and for exciting the plasma, **characterized in that** it comprises a series of elementary plasma excitation devices **(3)** each consisting of a wire microwave energy applicator **(4)** whereof one end is connected to the microwave energy production source **(E)** and whereof the other end is equipped, as means for creating at least one surface having a constant magnetic field and intensity corresponding to the electron cyclotron resonance, with at least one magnetic dipole **(5)** mounted at the end **(4₁)** of the microwave applicator **(4),** in order to ensure the oscillation between the poles of the electrons accelerated to the electron cyclotron resonance, in order to create a plasma diffusion zone **(Z)** located at least opposite the end of the applicator, with regard to the said dipole, the elementary excitation devices **(3)** being distributed between one another and close to the use surface **(S$_u$),** in order together to create a uniform plasma for the use surface.

7. Device according to Claim 6, **characterized in that** each elementary excitation device **(3)** comprises at least one magnetic dipole **(5)** whereof the magnetization axis **(A)** is substantially parallel to the axis of the wire applicator **(4).**

8. Device according to either of Claims 6 and 7, **characterized in that** each magnetic dipole **(5)** comprises at least one material **(15)** having high magnetic permeability, placed beyond the end **(4₁)** of the wire applicator, in order to modify the position of mirror points **(P₁, P₂)** associated with each pole of a magnetic dipole and between which electrons accelerated to the electron cyclotron resonance oscillate.

9. Device according to one of Claims 6 to 8, **characterized in that** each magnetic dipole **(5)** consists of an axially magnetized cylinder and in which an axial bore **(8)** is arranged and **in that** the diameter of the wire applicator **(4)** is equal to the diameter of the circle described by the magnetic pole, in order to prevent it from intersecting the trajectories of the electrons accelerated to the electron cyclotron resonance.

10. Device according to one of Claims 6 to 9, **characterized in that** each magnetic dipole **(5)** is provided with a line **(9)** for the entry of a cooling fluid mounted in an axial bore and communicating with a chamber **(11)** enveloping the magnetic dipole and terminating in a cooling fluid return line **(13).**

11. Device according to Claim 10, **characterized in that** the cooling fluid return line **(13)** is bounded between the inlet line **(9)** and a tube **(4)** forming the wire applicator.

**12.** Device according to one of Claims 9 to 11, **characterized in that** each magnetic dipole **(5)** is equipped with a gas inlet line **(14)** crossing the magnetic dipole via its axial bore **(8),**

**13.** Device according to one of Claims 6 to 12, **characterized in that** each elementary production device **(3)** is equipped with axial movement means for adjusting the distance between the use surface **(S$_u$)** and the magnetic dipole **(5).**

**14.** Device according to one of Claims 6 to 13, **characterized in that** each wire applicator **(4)** is connected by a coaxial structure **(4')** to an energy source **(E)** in the microwave range, outside the chamber **(1).**

**Patentansprüche**

**1.** Verfahren zur Produktion eines Plasmas für eine Nutzungsfläche (S$_u$) mit Hilfe einer Vorrichtung mit Mitteln für die Produktion einer Energie im Bereich der Mikrowellen und Mitteln zur Schaffung mindestens einer Fläche (6) mit konstantem Magnetfeld und einer der elektronischen zyklotronischen Resonanz entsprechenden Intensität, wobei diese Fläche zwecks Erregung des Plasmas mindestens im Ausbreitungsbereich der Mikrowellen platziert ist, **dadurch gekennzeichnet, dass** es darin besteht:

- eine Reihe von elementaren Vorrichtungen zur Plasmaerregung (3) zu bilden, die jeweils aus einem drahtgebundenen Applikator (4) einer Mikrowellenenergie bestehen, von dem ein Ende mit einer Produktionsquelle (E) einer Mikrowellenenergie verbunden ist und das andere Ende mit mindestens einem magnetischen Dipol (5) als Mittel zur Schaffung mindestens einer Fläche mit konstantem Magnetfeld und einer der elektronischen zyklotronischen Resonanz entsprechenden Intensität ausgestattet ist,

- den magnetischen Dipol (5) so am Ende (4$_1$) des Mikrowellenapplikators (4) anzubringen, dass die Schwingung zwischen den Polen der mit der elektronischen zyklotronischen Resonanz beschleunigten Elektronen gewährleistet wird, um eine Plasmadiffusionszone (Z) zu schaffen, die mindestens dem Endstück des Applikators, im Verhältnis zum Dipol, gegenüberliegt,

- und die elementaren Vorrichtungen für die Plasmaerregung (3) untereinander und nahe an der Nutzungsfläche (S$_u$) so zu verteilen, um mindestens ein Nebeneinander der von jeder elementaren Vorrichtung (3) produzierten Plasmen zu erzielen und damit ein einheitliches Plasma für die Nutzungsfläche zu schaffen.

**2.** Verfahren nach Anspruch 1, **dadurch gekennzeichnet, dass** es darin besteht, den Abstand zwischen den elementaren Erregungsvorrichtungen (3) und der Nutzungsfläche (S$_u$) zu regulieren, um die Plasmaerregung an das Profil der Nutzungsfläche anzupassen.

**3.** Verfahren nach Anspruch 1 oder 2, **dadurch gekennzeichnet, dass** es darin besteht, die Leistung der Mikrowellenenergie jeder elementaren Erregungsvorrichtung (3) zu regulieren, um das Plasma einheitlich einzustellen,

**4.** Verfahren nach Anspruch 1, **dadurch gekennzeichnet, dass** es darin besteht, die elementaren Vorrichtungen zur Plasmaerregung (3) so zu verteilen, dass die magnetischen Dipole (5) Magnetisierungsachsen besitzen, die in die gleiche Richtung ausgerichtet sind.

**5.** Verfahren nach Anspruch 1, **dadurch gekennzeichnet, dass** es darin besteht, die elementaren Vorrichtungen zur Plasmaerregung (3) so zu verteilen, dass die magnetischen Dipole (5) Magnetisierungsachsen besitzen, die abwechselnd von einer benachbarten Vorrichtung zu einer anderen ausgerichtet sind.

**6.** Vorrichtung zur Produktion eines Plasmas für eine Nutzungsfläche (S$_u$), wobei die Vorrichtung Mittel für die Produktion einer Energie im Bereich der Mikrowellen und Mittel zur Schaffung mindestens einer Fläche (6) mit konstantem Magnetfeld und einer der elektronischen zyklotronischen Resonanz entsprechenden Intensität umfasst, wobei die Fläche zwecks Erregung des Plasmas mindestens in Relation zum Ausbreitungsbereich der Mikrowellen platziert ist,
**dadurch gekennzeichnet, dass** sie eine Reihe von elementaren Vorrichtungen zur Plasmaerregung (3) umfasst, die jeweils aus einem drahtgebundenen Applikator (4) einer Mikrowellenenergie bestehen, von dem ein Ende mit der Produktionsquelle (E) verbunden ist und das andere Ende als Mittel zur Schaffung mindestens einer Fläche mit konstantem Magnetfeld und einer der elektronischen zyklotronischen Resonanz entsprechenden Intensität mit mindestens einem magnetischen Dipol (5) ausgestattet ist, der so am Ende (4$_1$) des Mikrowellenapplikators (4) angebracht ist, dass die Schwingung zwischen den Polen der mit der elektronischen zyklotronischen Resonanz beschleunigten Elektronen gewährleistet wird, um eine Plasmadiffusionszone (Z) zu schaffen, die dem Endstück (4$_1$) des Applikators im Verhältnis zum besagten Dipol gegenüberliegt, wobei die elementaren Vorrichtungen für die Erregung (3) untereinander und nahe an der Nutzungsfläche ($S_u$) verteilt sind, um ein einheitliches Plasma für die Nutzungsfläche zu schaffen.

7. Vorrichtung nach Anspruch 6, **dadurch gekennzeichnet, dass** jede elementare Erregungsvorrichtung (3) mindestens einen magnetischen Dipol (5) umfasst, dessen Magnetisierungsachse (A) ziemlich genau parallel zur Achse des drahtgebundanen Applikators (4) verläuft.

8. Vorrichtung nach Anspruch 6 oder 7, **dadurch gekennzeichnet, dass** jeder magnetische Dipol (5) mindestens ein Material (15) mit hoher magnetischer Durchlässigkeit umfasst, das über das Ende ($4_1$) der drahtgebundenen Applikators hinaus platziert ist, um die Position von Spiegelpunkten ($P_1$, $P_2$), die mit jedem Pol eines magnetischen Dipols kombiniert sind und zwischen denen mit elektronischer zyklotronischer Resonanz beschleunigte Elektronen schwingen, zu verändern.

9. Vorrichtung nach einem der Ansprüche 6 - 8, **dadurch gekennzeichnet, dass** jeder magnetische Dipol (5) aus einem axial magnetisierten Zylinder besteht, der mit einer axialen Bohrung (8) versehen ist, und dass der Durchmesser des drahtgebundenen Applikators (4) dem Durchmesser des vom magnetischen Pol beschriebenen Kreises entspricht, um zu vermeiden, dass er die Wege der mit elektronischer zyklotronischer Resonanz beschleunigten Elektronen schneidet.

10. Vorrichtung nach einem der Ansprüche 6 - 9, **dadurch gekennzeichnet, dass** jeder magnetische Pol (5) mit einer Leitung (9) für die Zuführung eines Kältemittels versehen ist, die in einer axialen Bohrung angebracht ist und mit einem Mantel (11) in Verbindung steht, der den magnetischen Dipol umhüllt und in einer Rückleitung (13) des Kältemittels mündet.

11. Vorrichtung nach Anspruch 10, **dadurch gekennzeichnet, dass** die Rückleitung (13) des Kältemittels zwischen der Zuleitung (9) und einem den drahtgebundenen Applikator bildenden Rohr (4) verläuft.

12. Vorrichtung nach einem der Ansprüche 9 - 11, **dadurch gekennzeichnet, dass** jeder magnetische Dipol (5) mit einer Gaszuleitung (14) ausgestaltet ist, die den magnetischen Dipol über seine axiale Bohrung (8) durchquert.

13. Vorrichtung nach einem der Ansprüche 6 - 12, **dadurch gekennzeichnet, dass** jede elementare Produktionsvorrichtung (3) mit Mitteln zur Axialverschiebung ausgestattet ist, um den Abstand zwischen der Nutzungsfläche ($S_u$) und dem magnetischen Dipol (5) zu regulieren.

14. Vorrichtung nach einem der Ansprüche 6 - 13, **dadurch gekennzeichnet, dass** jeder drahtgebundene Applikator (4) durch eine koaxiale Struktur (4') mit einer außerhalb des Mantels (1) liegenden Energiequelle (E) im Bereich der Mikrowellen verbunden ist.

FIG.1

FIG.2

FIG.3

FIG.5

FIG.4

FIG.6

FIG.7

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 8508836
- FR 9302414
- JP 05314918 B
- FR 9100894
- FR 9413499

**Littérature non-brevet citée dans la description**

- MICROWAVE EXCITED PLASMA. ELSEVIER, 1992, 368